# EUROPEAN PATENT APPLICATION

(11) **EP 4 730 948 A1**
(43) Date of publication of application: **22.04.2026**
(21) Application number: 25209052.7
(22) Date of filing: 16.10.2025
(51) Int. Cl.: H10D 8/00, H10D 8/01, H10D 62/10

(54) **PROCESS FOR MANUFACTURING A FAST RECOVERY INVERSE DIODE**

(30) Priority: 16.10.2024 US 202418917140
(71) Applicant: Littelfuse, Inc., Rosemont, Illinois 60018 (US)
(72) Inventor: Waind, Peter, Rosemont, 60018 (US)
(74) Representative: Arnold & Siedsma

(57) **Abstract**

A method may include providing a semiconductor substrate, comprising a first layer of a first thickness dopant, a first dopant polarity, and a first dopant concentration; and a second layer having a second thickness greater than the first thickness, a second polarity, and second dopant concentration, wherein the second layer defines a second dopant concentration, greater than the first dopant concentration. The method may further include forming a separation diffusion region having a dopant of the second dopant polarity around a periphery of the first layer, where the separation diffusion region extends from a first surface to a separation depth, greater than the first thickness of the first layer. The method may also include performing a thinning of the semiconductor substrate by removing a portion of the second layer from the second surface, wherein after the thinning, the second layer comprises a third thickness, less than the first thickness.

## Description

### BACKGROUND

### Field

The present disclosure relates to the field of diodes, and more particularly to fast recovery diodes.

### Discussion of Related Art

Diode devices for power semiconductor applications may be constructed within a semiconductor die (Chip) as vertical devices. Diode chips to be used for power applications are often constructed with the anode located on a top (bondable) surface of the semiconductor die and the cathode located on the bottom (solderable) surface. The diode is fabricated from a bulk semiconductor material, such as a silicon wafer of N-type, where the resistivity and thickness are selected to fit the chosen voltage grade for the diode. In the case of an N-type substrate, the anode is a P-type layer, and the cathode is formed of a relatively high concentration N-type layer.

So called fast recovery diodes are manufactured for high frequency applications such as freewheel diodes in power circuits, based upon a power semiconductor device, such as an insulated gate bipolar transistor (IGBT). These fast recovery diodes are designed to have a short recovery time together with soft recovery characteristics (free of snap and oscillations). These results can be achieved by applying known lifetime control techniques, or by using a low dose low injection efficiency anode, or a combination of these features.

In semiconductor package assemblies the cathode (bottom side) of the diode is usually soldered to the package base or substrate. The anode (top side) is connected by ultrasonic wire bonding or soldered contact, or by other techniques. While this arrangement is suitable in most configurations, there are situations where an inverse diode chip (anode at bottom, cathode at top) has advantages. The circumstance for using an inverse diode configuration may, for example, be for ease of circuit layout or space saving. In the case of a freewheel diode in an IGBT circuit the inverse diode may be mounted on top of the IGBT chip with a contact plate between the two chips providing a connection point to the emitter of the IGBT and the anode of the diode.

The characteristics of fast recovery diodes are optimized by careful design of the overall silicon wafer thickness, the anode diffusion profile, and by using lifetime control. As an example, conventional fast recovery diodes with anode on the top side, and rating of 1200 V, may require the N-layer to have approximately 100 µm in thickness. This overall thickness for the N-layer implies a total wafer thickness for the diode device to be similar- a thickness that is too thin for handling in a conventional wafer fabrication facility. Accordingly, the starting silicon substrate for fabricating the above diode is usually an epitaxial wafer with an N-layer arranged on an N+ substrate, or a pre-diffused silicon wafer with deep N-type diffusion, such as phosphorus. At the end of the wafer fabrication process, the N+ cathode can then be thinned to the targeted thickness for a given voltage range for the diode in order to improve performance.

Additionally, the blocking junction of a conventional diode with N- drift layer is formed at the top (anode) side. Junction termination and passivation can be achieved by well know techniques, guard rings, for example. In the case of the inverse diode, the blocking junction can be bought to the top (cathode) surface by means of an isolating diffusion (separation diffusion), and thus terminated on the top surface by conventional methods. The separation diffusion technique is suitable for manufacture of conventional inverse rectifier (slow) grade diodes. In this case, aluminum may be diffused simultaneously from both sides of the wafer to form isolating regions that extend from opposite surfaces of the wafer and join one another in the middle of the wafer. However, this method will result in an N- layer that is too thick for a forming a fast recovery diode of suitable properties. A 1200V fast recovery diode with suitable performance needs a thin N- layer (~100 µm) and also a low concentration anode diffusion.

With respect to these and other considerations, the present disclosure is provided.

### SUMMARY

A method of forming a fast recovery inverse diode is provided. The method may include providing a semiconductor substrate, the semiconductor substrate comprising a first layer extending from a first main surface, comprising a dopant of a first polarity, and a second layer, extending from a second main surface, opposite the first main surface, comprising a dopant of a second polarity. As such, the first layer and the second layer may define a P/N junction within the semiconductor substrate, wherein the first layer defines a first thickness, where the second layer defines a second thickness, greater than the first thickness, and where the first layer defines a first dopant concentration, wherein the second layer defines a second dopant concentration, greater than the first dopant concentration. The method may further include forming a separation diffusion region around a periphery of the first layer, wherein the separation diffusion region comprises a dopant of the second polarity, where the separation diffusion region extends from the first surface to a separation depth that is greater than the first thickness of the first layer. The method may also include forming a contact structure on the first main surface, and performing a thinning of the semiconductor substrate by removing a portion of the second layer from the second surface, wherein after the thinning, the second layer comprises a third thickness, less than the first thickness.

The semiconductor substrate may comprise an N-type layer, extending from a first main surface and having a first thickness, and a P-type layer, extending from a second main surface, opposite the first main surface, and having a second thickness, greater than the first thickness, where the N-type layer and the P-type layer define a P/N junction within the semiconductor substrate. The method may include forming a separation diffusion region around a periphery of the first layer, where the separation diffusion region comprises a p-type dopant, and where the separation diffusion region extends from the first surface to a separation depth that is greater than the first thickness of the first layer. The method may also include forming a cathode contact structure on the first main surface, and performing a thinning of the semiconductor substrate by removing a portion of the P-type layer from the second surface, wherein after the thinning, the second layer comprises a third thickness, less than the first thickness.

IA fast recovery inverse diode is also provided. The fast recovery diode may include a first layer, extending from a first surface, comprising a dopant of a first polarity; and a second layer, extending from a second surface, opposite the first surface, comprising a dopant of a second polarity, wherein the first layer and the second layer define a P/N junction within the semiconductor substrate, wherein the first layer defines a first thickness, wherein the second layer defines a second thickness, greater than the first thickness. The fast recovery diode may also include a separation diffusion region around a periphery of the first layer, wherein the separation diffusion region comprises a dopant of the second polarity, wherein the separation diffusion region extends from the first surface to a separation depth that is greater than the first thickness of the first layer, wherein the second layer comprises a thinned layer, formed by thinning the semiconductor substrate from the second surface, wherein the semiconductor substrate comprises a diameter of at least 125 mm, and wherein the semiconductor substrate comprises a thickness of less than 200 µm.

Use of the fast recovery inverse diode in a power semiconductor application is also provided.

### BRIEF DESCRIPTION OF DRAWINGS

FIGs. 1A-1F illustrate the fabrication of a device, in side cross section, at various stages, according to the disclosure;
FIG. 1G depicts the device of FIG.1F in top plan view;
FIGs. 2A-2G illustrate the fabrication of another device at various stages, according to the disclosure; and
FIG. 3 presents an exemplary process flow.

### DETAILED DESCRIPTION

A fast recovery inverse diode may be fabricated using a pre-diffused semiconductor wafer. Such wafers may be provided by wafer suppliers where a deep phosphorus or boron diffusion is applied into one side of a given silicon wafer (substrate). The dopant type and resistivity of the starting silicon substrate, and the diffusion depth may be chosen to suit a given application for a diode to be manufactured.

In the case of a 1200 V fast recovery inverse diode, the starting silicon substrate may be selected to be n-type with a resistivity of approximately 40 Ohm-cm and 300 µm thickness. The deep diffusion layer may be boron (P-Type) to a depth of approximately 200 µm, making a P/N junction with the N-type starting silicon substrate. The substrate need not be polished at this stage. The boron-diffused side will then become the anode (bottom side) of the final diode device to be fabricated.

A p-type separation diffusion (such as aluminum) may be employed to bring the P/N junction to the top surface of the wafer for termination that is accomplished by applying conventional techniques, using guard rings, for example. The aluminum diffusion may be performed from the top (cathode) side of the wafer and patterned in order to enclose the active potion of the diode. During the separation annealing to form the P-type separation regions, the aluminum-doped regions will merge with the anode-side boron doped regions. The P-type separation regions may be formed based upon boron diffusion, for example, lower voltage options having a thinner N- layer.

Following the separation diffusion processing, the top side of the wafer may be polished to a standard compatible with further processing. An N-type diffusion into the top side of the wafer may then be performed to fabricate the cathode of the diode. This N-type diffusion may be a single diffusion, or have a double diffusion profile to have a high surface concentration for good ohmic contact to a metallization, but also a low doped transition to the N-layer for soft recovery characteristics. Any junction termination structures, such as guard rings, may also be added to the top side of the wafer, although these structures may be optional, since the junction topology is favorable for promoting the desired breakdown voltage.

The top side processing of the wafer for diode fabrication may be completed by the application of cathode metallization, such as aluminum, although other contact schemes are possible. Dielectric passivation layers may be added to the junction termination area to improve stability.

After completion of the top (front - cathode) side processing the bottom (backside - anode) of the wafer may be thinned by using a grind and etch process, removing most of the thickness of the deep p-type diffusion. A remaining lightly doped P-layer will form an anode with low injection efficiency. The thickness and concentration of this layer will be designed to impart the desired fast and soft recovery characteristics of the diode being fabricated. A thin, highly doped, contact p-layer may be added (by ion implantation and laser activation, for example) to the anode side for good ohmic contact to a metallization layer.

As detailed below, the fabrication of a diode device may be completed by application of Anode metallization. As an example, , solderable Al-Ti-Ni-Ag metallization may be applied for the Anode bottom side.Other contact metallization schemes may be possible, as known in the art. Lifetime control may also be performed to tailor the diode properties, for example, by electron irradiation of the substrate, or implant of ions such as helium, or by diffusion of metals such as platinum.

A Fast Recovery Inverse Diode may be manufactured using an epitaxial starting material as an alternative to a pre-diffused silicon substrate. The substrate silicon may be p-type, boron doped, and the epitaxial layer n-type. As with embodiments of pre-diffused silicon wafers, the n-layer may be approximately 100 µm thick and have 40 Ohm-cm resistivity. During a subsequent separation diffusion thermal cycle boron may diffuse from the substrate into the N-layer to form a low doped anode. The resistivity of the substrate may be chosen to impart an optimum anode diffusion profile. The process flow after the separation diffusion operation may closely follow the flow for fabricating inverse diodes pre-diffused silicon substrates, with the exception being that, during a grind and etch process, the original substrate layer may be completely removed, leaving just the diffused boron layer for a lightly dope anode layer.

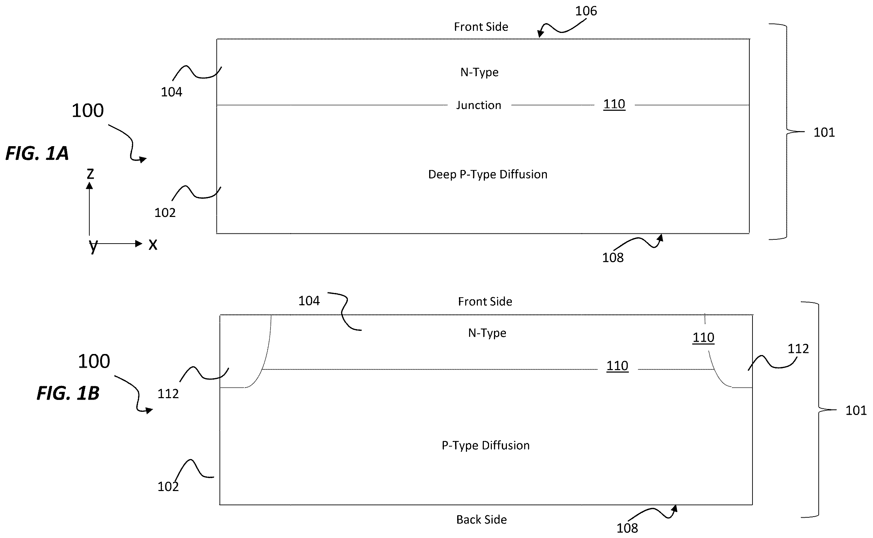

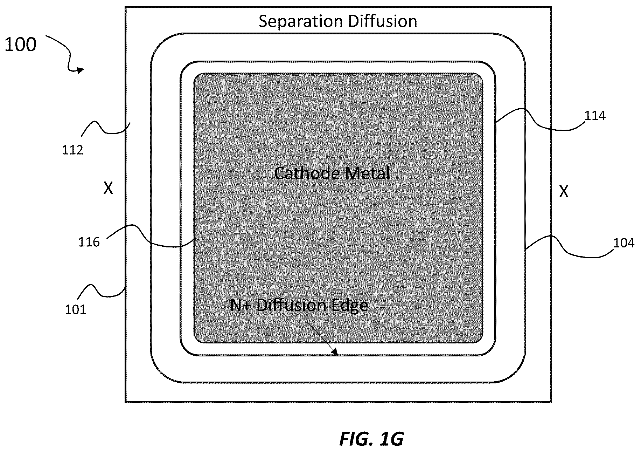

Turning to the figures, in FIG. 1A-1F the fabrication of a device is illustrated at various stages.. Turning to **FIG. 1A** there is depicted a fast recovery, inverse diode, shown as device 100, at an early fabrication stage. For purposes of illustration, the views shown may be considered to be a cross-sectional view of a substrate in the form of a semiconductor wafer, such as monocrystalline silicon. The device 100 may include a first main surface 106, which surface may be deemed a 'front side,' and second main surface 108, which surface may be deemed a 'back side,' being situated opposite the first main surface 106. At the stage of FIG. 1A, an N-substrate, which feature is represented as substrate 101, has been subjected to doping of a P-type dopant, such as boron. The substrate 101 may be fabricated from an N-type monocrystalline silicon crystal having resistivity in the range of 40 Ohm-cm. The P-type dopant may be introduced into the substrate 101 according to known techniques by diffusing the dopant at high substrate temperature into an N-type substrate, from the second main surface 108. Thus, the first main surface 106 may thus be protected during the diffusing of the P-type dopant. A suitable manufacturing process for deep diffused wafers may be to start with a thick wafer and diffuse simultaneously from both sides (this approach avoids stress and bowing issues). Afterwards the wafers are sliced through the center and surfaces prepared to give two wafers with deep diffusion from one side. At this stage, the P-type dopant may occupy a substantial thickness of the total thickness of the substrate 101. The overall substrate thickness of substrate 101 may initially be in the range of 300 µm to 500 µm, the thickness of the P-diffusion layer 102 may be 300 µm to 400 µm. In this scenario, the junction 110 may thus form at a depth of 100 µm to 200 µm from the first main surface 106, leaving an N-type region of such a thickness that extends from the first main surface 106. The front side, first main surface 106 may be polished at the stage of FIG. 1A.

Turning to **FIG. 1B****,** there is shown a subsequent stage where a separation diffusion has been performed. At this stage, a separation diffusion region 112 has been formed. The separation diffusion region 112 may represent a P-type region that has been formed by diffusion of a P-type dopant from the first main surface 106. Note that the second main surface 108 need not be protected during this operation, since a large portion of the backside silicon is removed subsequently. The separation diffusion region 112 may be generated by introducing aluminum (Al) into the first main surface 106, or alternatively may be generated using a boron dopant. Note that the separation diffusion region 112 is generated to extend to a depth that is greater than the thickness of the N-type region 104, so that the separation diffusion region 112 joins the P-diffusion layer 102. Note also that the junction 110 is thus brought to the first main surface 106. In this manner, the device 100 may be constructed to support a full breakdown field at a designed voltage, such as 1200 V.

It may be appreciated by those of skill in the art that the separation diffusion region 112 may extend in the plane of the substrate 101 (X-Y plane of the Cartesian coordinate system shown) as a border surrounding the N-type region 104. In some examples, the separation region may have a rectangular moat shape, a square moat shape in the X-Y plane, an oval moat shape, or other suitable shape that surrounds the periphery of the N-type region 104 in the X-Y plane. As such, the separation diffusion region 112 may define an individual diode device within a wafer that is to be diced at a subsequent instance. Thus, for simplicity of explanation, the view in FIG. 1B may present a representation of the device 100 after dicing, while it may be understood that at the stage of FIG. 1B, the substrate 101 may be intact, and may include an array of contiguous structures as represented in FIG. 1B. In order to form the separation diffusion region 112, it may be understood that the first main surface 106 may be patterned so as to expose the first main surface to P-type dopant just in the peripheral regions of the first main surface 106, as shown.

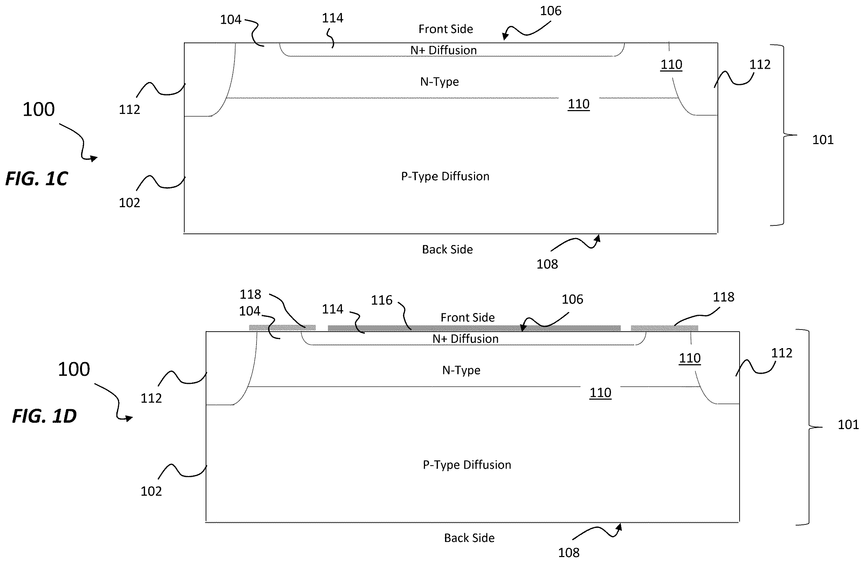

Turning to **FIG. 1C****,** there is shown a subsequent stage, where cathode diffusion takes place. In one example, a phosphorous (N-type) dopant is introduced into the first main surface 106, to form the N+ layer 114. The operation of FIG. 1C may be performed in a double diffusion process to generate high surface dopant concentration, but also a low-doped transition to the N-type region 104 for producing soft recovery characteristics in the device 100.

Turning to **FIG. 1D**, there is shown a subsequent stage where front side processing has been completed. At this stage, front side metal contact may be formed, such as a cathode metal layer 116, such as aluminum, has been formed, over a portion of the N+ layer 114. The formation of the cathode metal layer 116 may take place using known processing. In addition, a passivation layer 118 has been formed to cover a region that extends from N+ layer 114 to separation diffusion region 112. Note that the passivation layer 118 may peripherally surround the N+ diffusion layer 114 within the X-Y plane. Examples of suitable material for passivation layer 118 include oxide, silicon nitride, and so forth. Additional termination features (not shown) may be added to the first main surface 106, which features may extend under the passivation layer118. Such features may include guard rings or junction terminal extensions, for example. Diffusion processes to form such features would need to be added before the passivation and metallization processes take place.

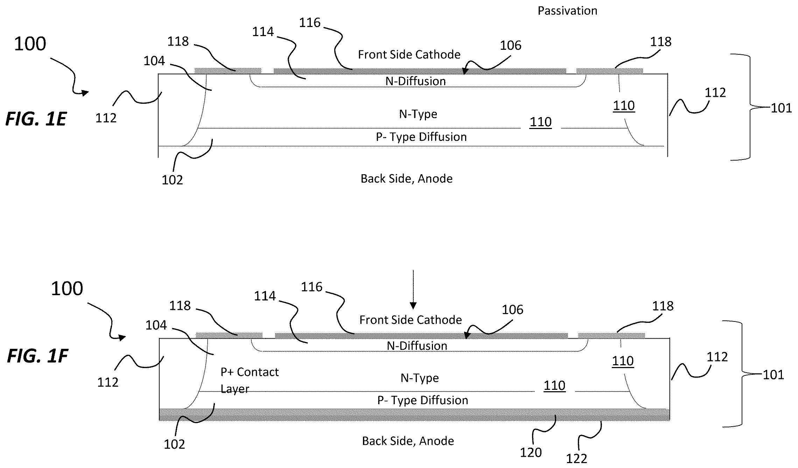

Turning to **FIG. 1E**, there is shown a subsequent stage where wafer thinning has been performed. At this stage, the second main surface 108 may be subject to grinding and etching in order to remove a substantial portion of the thickness of the substrate 101. The P-diffusion layer 102 may be reduced in thickness so as to leave a small thickness, such as just 25 µm of P-diffusion layer 102. For example, in a case where the thickness of the N-type region is 100 µm, the total wafer thickness of substrate 101 at this stage may be 125 µm.

Turning to **FIG. 1F**, there is shown a subsequent stage where back side processing has been completed. In particular, a P+ contact layer 120 has been performed by introducing a dopant through the second main surface 108. This process may be accomplished by implanting boron, for example, followed by laser annealing to activate the P+ contact layer 120. In addition, an anode metal layer 122 has been formed. The anode metal layer 122 may be, for example, a solderable layer, such as Aluminum/Titanium/Nickel/Silver, or other suitable metallurgical combination, as known in the art.

Subsequent to the operation of FIG. 1F, additional processing of the substrate 101 may be performed, such as lifetime control processing, electron irradiation, and/or implant of ions such as helium or protons, and so forth. This operation is necessary to speed up the recovery process, so is an integral part of Fast Recovery Diode. Toward this end, diffusion into the silicon substrate of heavy metals such as platinum or gold may be performed, but this introduction of heavy metals would need to be performed earlier, before metal and passivation processes. In addition, wafer probing, dicing into individual die, and assembly into discrete packages or modules containing several die of different kinds may take place, where each inverse diode die may represent a diode having the general appearance as shown in FIG. 1F.

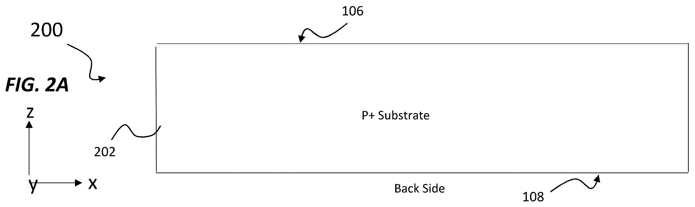

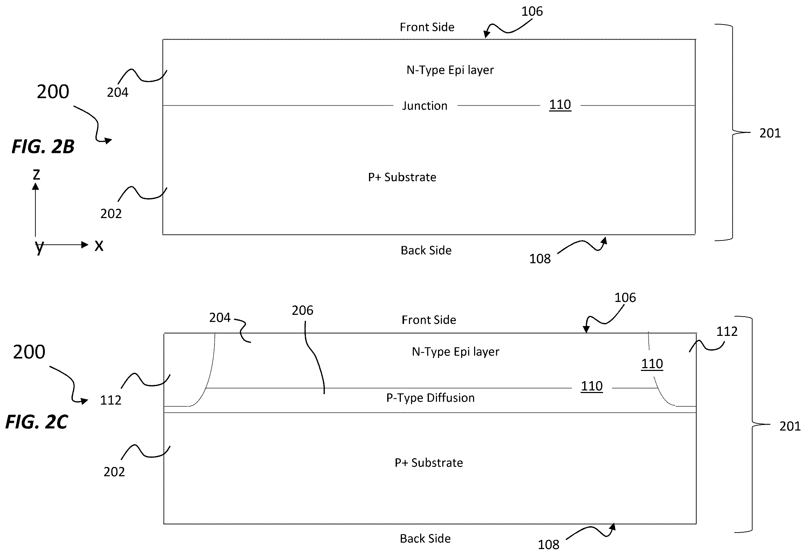

FIGs. 2A-2F show the fabrication of another device at various stages, , where features of FIGs. 2A-2F that are similar to those features of FIGs. 1A-1F being labeled the same. Turning to **FIG. 2A** there is depicted a fast recovery, inverse diode, shown as device 200, at an early fabrication stage. The device 200 may include a first main surface 106, and second main surface 108, as described above. At the stage of FIG. 2A, P-type substrate 202, such as a P+ substrate is provided, such as a Boron doped substrate that is polished on the first main surface 106. The overall thickness of the P-type substrate 202 may be 300 µm to 600 µm. The substrate resistivity may be selected to produce an optimum final anode profile. At the stage of **FIG. 2B****,** an N-Type epitaxial layer 204 has been formed on the front side of the P-type substrate 202. Together, the P-type substrate 202 and epitaxial layer 204 constitute a thicker substrate, labeled as substrate 201. Thus, the first main surface 106 of the substrate 201 represents the outer surface of the N-Type epitaxial layer 204. The resistivity of the N-Type epitaxial layer 204 may be~ 40 Ohm-cm, while the thickness of the N-type epitaxial layer 204 is ~120µm. The overall thickness of the substrate 201 at the stage of FIG. 2A may be 400 µm, 450 µm, 500 µm, or greater (often 600µm). At such overall thickness, the substrate 201 may have a mechanical stability that is suitable for processing in a wafer fabricator without undue modification of processing tools or undue risk of wafer breakage.

Turning to **FIG. 2C****,** there is shown a subsequent stage where a separation diffusion has been performed. At this stage, a separation diffusion region 112 has been formed. The separation diffusion region 112 may be formed in a manner similarly to FIG. 1B. Note that during the separation diffusion operation, the P-dopant, such as boron, may diffuse upwards from the P-type substrate 202, forming a P-type diffusion layer 206, where the dopant profile depends on the substrate resistivity and diffusion time. Note that the separation diffusion region 112 may be arranged to at least penetrate into the P- type diffusion layer 206 sufficiently to support the electric field under reverse voltage up to the rated breakdown voltage.

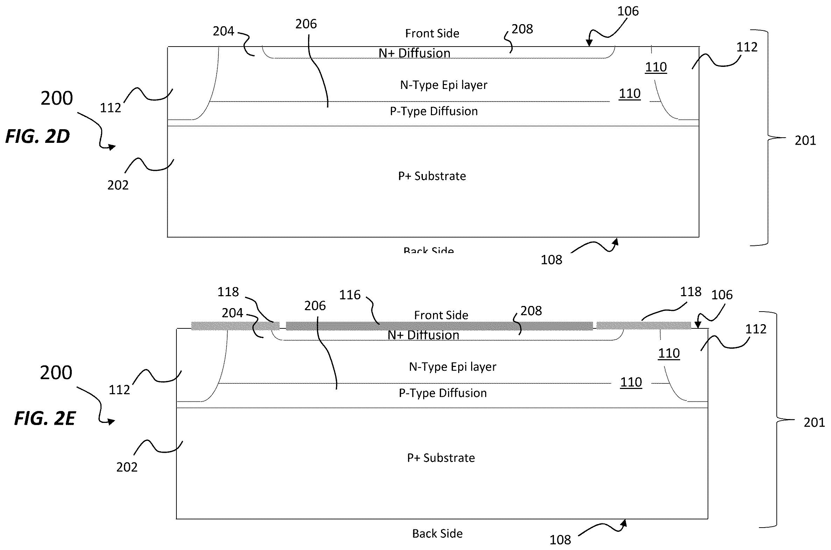

At **FIG. 2D****,** there is shown a subsequent stage, where cathode diffusion takes place, to form the N+ layer 208, as described above with respect to FIG. 1C.

At **FIG. 2E****,** there is shown a subsequent stage where front side processing has been completed. At this stage, a cathode metal layer 116, such as aluminum, has been formed, over a portion of the N+ layer 208, (and optionally passivation, and guard rings etc. (not separately shown) if necessary) as described above with respect to FIG. 1D.

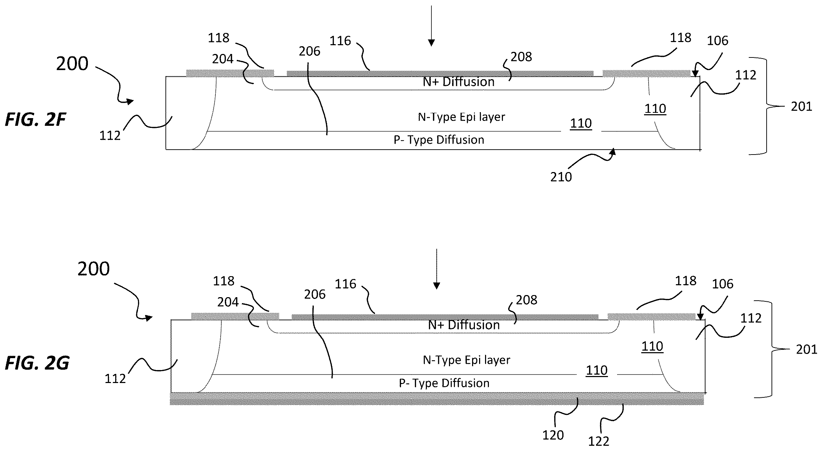

Turning to **FIG. 2F****,** there is shown a subsequent stage where wafer thinning has been performed. At this stage, the second main surface 108 may be subject to grinding and etching in order to remove a substantial portion of the thickness of the substrate 201, in particular, by etching the portion of substrate 201 represented by the original P-type substrate, that is, P-type substrate 202. The P-type substrate 202 may be reduced in thickness so as to completely remove the P-type substrate 202. For example, in a case where the thickness of the remaining N-type epitaxial layer 204 plus the P-type diffusion layer 206 is 100 µm, the total wafer thickness of substrate 201 at this stage may be 100 µm. A small thickness of the P-type substrate 202 may be preserved at the stage of FIG. 2E, such as a thickness of 25 µm or 50 µm. The final P-type profile in the P-type diffusion layer 206 will help determine diode performance of the device 200.

Turning to **FIG. 2G****,** there is shown a subsequent stage where back side processing has been completed. In particular, a P+ contact layer 120 has been performed by introducing a dopant through the second main surface 108. This process may be accomplished by implanting boron, for example, followed by laser annealing to activate the P+ contact layer 120. In addition, an anode metal layer 122 has been formed. The anode metal layer 122 may be, for example, a solderable layer, such as Aluminum/Titanium/Nickel/Silver, or other suitable metallurgical combination, as known in the art. The P+ contact layer 120 may be omitted.

Subsequent to the operation of FIG. 2G, additional processing of the substrate 201 may be performed, such as described above.

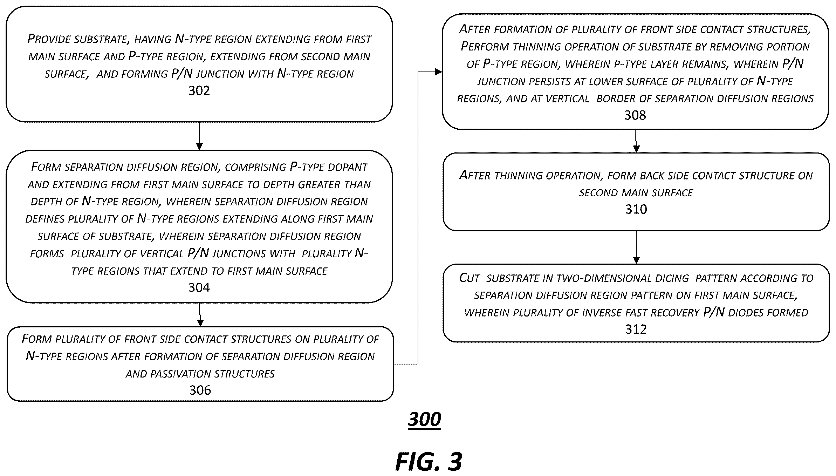

**FIG. 3** presents an exemplary process flow 300. At block 302, a substrate is provided, having an N-type region extending from a first main surface and a P-type region, extending from a second main surface. As such, the P-type region forms a P/N junction with the N-type region. The substrate may be a semiconductor wafer, such as silicon, having a diameter of 125 mm, 200 mm, or 300 mm. The substrate may have a thickness of 300 mm, 400 mm, or 500 mm or more (particularly in case of larger diameter wafers and or substrates that include an epitaxial layer process). The P-type region may be a layer of P-type dopant that is diffused into an N-type substrate from the second main surface, leaving a portion of the N-type substrate to define the N-type region. The P-type region may be a portion of a P-type substrate, where an N-type epitaxial layer is grown on the P-type substrate to form the N-type region.

At block 304, a separation diffusion region is formed, comprising a P-type dopant. The separation region extends from the first main surface to a depth greater than a depth of the N-type region, where the separation diffusion region defines a plurality of N-type regions extending along the first main surface of the substrate. As such, the plurality of N-type regions may be arranged in a two-dimensional array to form a plurality of P/N diodes. As such, the separation diffusion region may form a plurality of vertical P/N junctions with the plurality N-type regions that extend to the first main surface.

At block 306, a plurality of front side cathode N+ diffusions and contact structures are formed on the plurality of N-type regions after the formation of the separation diffusion region, as well as passivation structures.

At block 308, after the formation of the plurality of front side contact structures, a thinning operation of the substrate is performed by removing a portion of the P-type region, wherein a p-type layer remains after the thinning. As such, a horizontal P/N junction persists at a lower surface of the plurality of N-type regions, and at the vertical border of the separation diffusion region.

At block 310, after the thinning operation, a back side metal contact structure is formed on the second main surface.

At block 312, the substrate is cut in a two-dimensional dicing pattern according to the separation diffusion region pattern previously formed on the first main surface. As such, a plurality of inverse fast recovery P/N diodes are formed.

Note that the aforementioned including ranges of thickness for various layers may be particularly suitable for diodes rated at a given voltage, such as 1200 V. It may be understood that the various thicknesses, including the optimum N-layer thickness may be adjusted to be greater or lesser for embodiments directed to lower voltage diodes, such as 600 V, or higher voltage diodes, such as 1200 (and higher) V.

Moreover, inverse diodes may be fabricated based upon P-type substrates, into which substrates, an N-type diffusion takes place to form a PN junction. Inverse diode fabrication may take place by epitaxial growth of a P-type epitaxial layer on an N-type substrate

The present disclosure is not to be limited in scope by the examples described herein. Indeed, other variations s of and modifications to the present disclosure, in addition to those described herein, will be apparent to those of ordinary skill in the art from the foregoing description and accompanying drawings. Thus, such other variations and modifications are intended to fall within the scope of the present disclosure. Further, although the present disclosure has been described herein in the context of a particular implementation, in a particular environment for a particular purpose, those of ordinary skill in the art will recognize that its usefulness is not limited thereto and that the present disclosure may be beneficially implemented in any number of environments for any number of purposes. Accordingly, the claims set forth below should be construed in view of the full breadth of the present disclosure as described herein.

## Claims

1. A method of forming a fast recovery inverse diode, comprising:
providing a semiconductor substrate, the semiconductor substrate comprising a first layer extending from a first main surface, comprising a dopant of a first polarity, and a second layer, extending from a second main surface, opposite the first main surface, comprising a dopant of a second polarity, wherein the first layer and the second layer define a P/N junction within the semiconductor substrate, wherein the first layer defines a first thickness, wherein the second layer defines a second thickness, greater than the first thickness, wherein the first layer defines a first dopant concentration, wherein the second layer defines a second dopant concentration, greater than the first dopant concentration;
forming a separation diffusion region around a periphery of the first layer, wherein the separation diffusion region comprises a dopant of the second polarity, wherein the separation diffusion region extends from the first main surface to a separation depth that is greater than the first thickness of the first layer;
forming a contact structure on the first main surface; and
performing a thinning of the semiconductor substrate by removing a portion of the second layer from the second main surface, wherein after the thinning, the second layer comprises a third thickness, less than the first thickness.

2. The method of claim 1, wherein the dopant of the first polarity is a n-type dopant and the dopant of the second polarity is an p-type dopant,
or
wherein the dopant of the first polarity is a p-type dopant and the dopant of the first polarity is an n-type dopant.

3. The method of claim 1 or 2, wherein the separation diffusion region is formed using an Al-dopant, or a boron dopant.

4. The method of any of the preceding claims forming the contact structure further comprising:
forming a surface diffusion layer in the first layer, comprising the dopant of the first polarity;
forming a front side metal contact on the surface diffusion layer; and
forming a passivation layer over a portion of the second surface, the passivation layer extending between the surface diffusion layer and the separation diffusion region.

5. The method of any of the preceding claims, further comprising forming a backside metal contact on the second main surface after the thinning.

6. The method of any of the preceding claims, wherein the substrate comprises a silicon wafer having a diameter of 125 mm or greater, and wherein the substrate comprises a total thickness of 250 µm or greater before the thinning, preferably wherein the substrate comprises a total thickness of less than 250 mm after the thinning.

7. The method of any of the preceding claims, wherein the second layer is formed by diffusing a dopant of the second polarity into a substrate of the first polarity.

8. The method of any of the preceding claims, wherein the first layer is formed by growth of an epitaxial layer of the first polarity on a substrate base of the second polarity.

9. The method of any of the preceding claims, wherein the first layer comprises an N-type layer and the second layer comprises a P-type layer, wherein the contact structure is a cathode contact structure.

10. The method of claim 9, wherein the P-type layer is formed by diffusing a P-type dopant into an N-type substrate.

11. The method of claim 9 or 10, wherein the N-type layer is formed by growth of an epitaxial N-type layer on a P-type substrate base.

12. The method of any of the preceding claims, wherein the separation diffusion region defines a plurality of N-type regions extending along the first main surface of the semiconductor substrate.

13. The method of any of the preceding claims, wherein the separation diffusion region defines a P/N junction that extends to the first main surface of the semiconductor substrate.

14. A fast recovery inverse diode, comprising:
a first layer, extending from a first surface of a semiconductor substrate, comprising a dopant of a first polarity;
a second layer, extending from a second surface, opposite the first surface, comprising a dopant of a second polarity, wherein the first layer and the second layer define a P/N junction within the semiconductor substrate, wherein the first layer defines a first thickness, wherein the second layer defines a second thickness, greater than the first thickness; and
a separation diffusion region around a periphery of the first layer, wherein the separation diffusion region comprises a dopant of the second polarity, wherein the separation diffusion region extends from the first surface to a separation depth that is greater than the first thickness of the first layer,
wherein the second layer comprises a thinned layer, formed by thinning the semiconductor substrate from the second surface, wherein the semiconductor substrate comprises a diameter of at least 125 mm, and wherein the semiconductor substrate comprises a thickness of less than 200 µm.

15. Use of a fast recovery inverse diode according to claim 14 in a power semiconductor application.
